# EUROPÄISCHE PATENTSCHRIFT

(11) **EP 0 697 804 B1**
(45) Veröffentlichungstag und Bekanntmachung des Hinweises auf die Patenterteilung: **09.02.2000**
(21) Anmeldenummer: 95108378.1
(22) Anmeldetag: 01.06.1995
(51) Int. Cl.: H05K 1/02, H01R 24/00

(54) **Leiterplatte für Steckverbinder**
Printed circuit board for plug connector
Plaque à circuit imprimé pour connecteur à fiche

(30) Priorität: 09.08.1994 DE 9412794 U
(43) Veröffentlichungstag der Anmeldung: 21.02.1996
(73) Patentinhaber: KRONE Aktiengesellschaft, 14167 Berlin (DE)
(72) Erfinder: Kerndlmaier, Walter, Dr., D-85521 Riemerlink (DE)

(56) Entgegenhaltungen:
- EP-A- 0 134 899
- DE-U- 9 012 222
- GB-A- 2 268 336
- GB-A- 2 269 941
- GB-A- 2 270 422
- US-A- 5 269 708
- US-A- 5 295 869

## Beschreibung

Die Erfindung bezieht sich auf eine Leiterplatte für Steckverbinder in symmetrischen Verteilernetzen der Kommunikations- und Datentechnik.

Die bei heutigen Verteilernetzen auftretenden Betriebsfrequenzen von bis zu 100 MHz erfordern eine sorgfältige Auslegung aller Komponenten des Verteilernetzes, insbesondere auch der Steckverbindungen in den Patchfeldern. Es stellen sich hierbei vornehmlich drei Anforderungen an das Übertragungsverhalten der Komponenten, nämlich bezüglich der Einfügedämpfung, der Rückflußdämpfung und des Nebensprechverhaltens. Insbesondere das Nebensprechverhalten ist neben der Kabeldämpfung die die maximale Übertragungsleistung wesentlich bestimmende Größe. Daher sind neben einem von Hause aus nebensprecharmen Design üblicherweise noch zusätzliche Kompensationsmaßnahmen in den einzelnen Komponenten notwendig. Die von den Komponenten solcher Verteilernetze zu erfüllenden Anforderungen sind z.B. in der amerikanischen Norm ANSI/EIA/TIA-568 ("Commercial Building Telecommunications Wiring Standard") und dem zugehörigen "Supplement Technical Systems Bullletin" TIA/EIA TSB 40 festgelegt. Vom besonderem Interesse ist die Kategorie 5 dieses Standards, die von Steckverbindungen z.B. eine Nahnebensprechdämpfung (NEXT) von mindestens -40 dB zwischen den einzelnen Leiterpaaren bei einer Betriebsfrequenz von 100 MHz fordert. Diese Forderung ist von Standard-Steckverbindungen mit gleichmäßigen Kontaktabstand kaum mehr zu erfüllen und macht komplizierte Leitergeometrien bzw. Kompensationsschaltungen notwendig.

Aus der US 5 295 869 ist ein Steckverbinder bekannt, bei dem auf einer Zusatzplatine eine kapazitive Kompensation des Nahnebensprechens mittels eng benachbarter Durchkontaktierungen erfolgt. Außerdem sind in dieser Druckschrift die anderen bekannten Möglichkeiten zur Kompensation des Nebensprechens der Komponenten aufgezählt: Verwendung von diskreten Kompensationskapazitäten, Ausbildung von kapazitiven Flächen auf zugehörigen Leiterplatten, induktive Kopplung mittels paralleler Leiterführung auf zugehörigen Leiterplatten, sowie zusätzlich kompensierende Leiterabschnitte.

Nachteilig bei diesen bekannten Kompensationsverfahren für Steckerverbinder sind die mangelnde Zuverlässigkeit von diskreten Kompensationskapazitäten oder zusätzliche kompensierende Leiterabschnitte, sowie die erhöhten Herstellungskosten durch zusätzliche notwendige Verfahrensschritte.

Aus der DE 43 25 952.9 ist eine Kontaktleiste für Verteilernetze bekannt, bei der durch Verringerung der Kontaktabstände zwischen den beiden Leitern der verdrillten Doppelleitungen bei gleichbleibendem Kontaktabstand zwischen den verschiedenen Doppelleitungen eine Nahnebensprechdämpfung von besser als -60 dB bei Ausführung als Schalt- oder Anschlußleiste erzielt wird. Nachteilig ist, daß bei dieser Ausführung der Kontaktleiste als Trennleiste die Nahnebensprechdämpfung zwischen gegenüberliegenden Doppelleitungen bei Verwendung herkömmlicher Steckverbinder auf bis zu -40 dB steigt, was weitere Kompensationsmaßnahmen am Stecker erfordert.

Von daher ist es Aufgabe der Neuerung, einen Steckverbinder zu schaffen, der unter Vermeidung diskreter Kompensationsmaßnahmen für alle Ausführungsarten der Kontaktleiste zwischen allen Kontaktpaaren eine Nahnebensprechdämpfung im Bereich von -60 dB erreicht.

Die Lösung der Aufgabe ergibt sich aus den kennzeichnenden Merkmalen des Schutzanspruchs 1. Durch die Führung der Leiterbahnen wird sowohl eine teilweise magnetische Selbstkompensation zwischen dem Steckverbinder und der Kontaktleiste als auch ein geringeres Nebensprechen innerhalb des Steckers erzielt. Die magnetische Selbstkompensation geschieht durch an die Kontaktflächen anschließenden Leiterbahnabschnitte, die im wesentlichen parallel und eng benachbart zu den Kontaktfedern der Kontaktleiste laufen, wohingegen die Nahnebensprechdämpfung im Steckverbinder vor allem durch die nahezu deckungsgleiche Leiterbahnführung auf Vorder- und Rückseite der Leiterplatte minimiert wird. Weitere vorteilhafte Ausgestaltungen der Neuerung ergeben sich aus den Unteransprüchen. Die Verengung der parallelen Leiterbahnführung führt zu einer Anpassung des Wellenwiderstandes an eine 100 Ohm-Umgebung und somit zur Vermeidung von Reflexionen. Durch die Verbindung der Leiterbahnen mit kapazitiven Flächen wird eine verbesserte Wellenwiderstandsanpassung erreicht. Zusätzlich dienen diese zur Kompensation des Nebensprechens zwischen Vorder- und Rückseite der Leiterplatte, wobei diese hauptsächlich die Einflüße der Kontaktflächen kompensieren. Um von der magnetischen Selbstkompensation nicht erfaßtes Nebensprechen der Kontaktleiste zu kompensieren, werden die kapazitiven Flächen vorzugsweise etwas größer als die zugehörigen Kontaktflächen ausgelegt.

Die Neuerung ist nachfolgend anhand eines in den Zeichnungen dargestellten Ausführungsbeispieles näher erläutert. Es zeigen:
- Fig. 1: eine Seitenansicht einer Kontaktleiste mit eingesteckter Leiterplatte des Steckverbinders;
- Fig. 2: eine Schnittdarstellung der Kontaktleiste mit eingesteckter Leiterplatte;

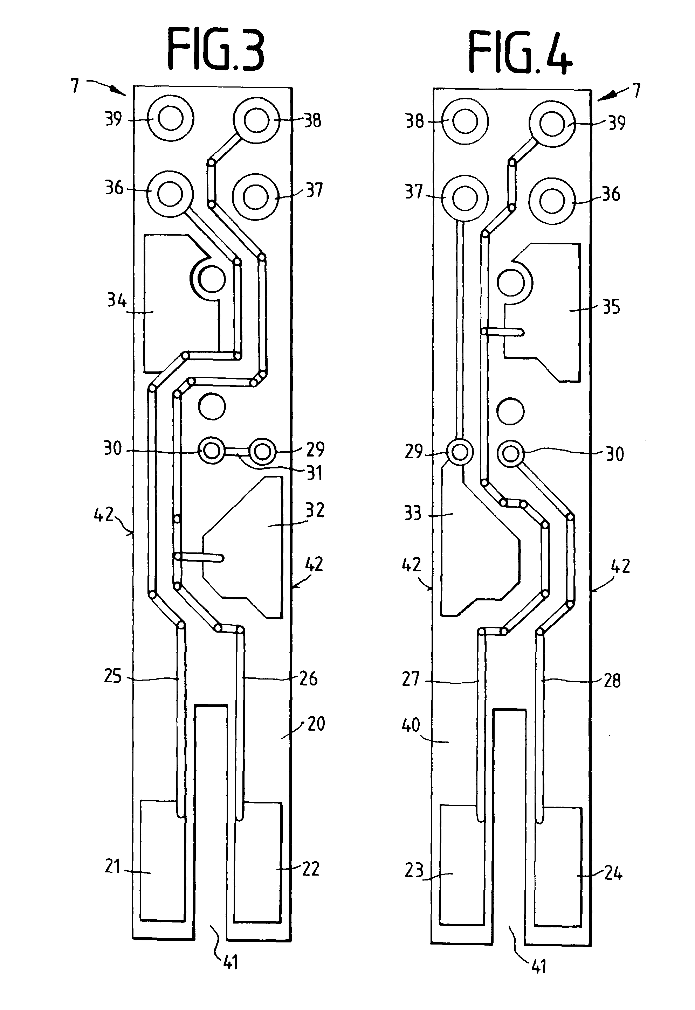

- Fig. 3: eine Draufsicht auf die Vorderseite der Leiterplatte und
- Fig. 4: eine Draufsicht auf die Rückseite der Leiterplatte.

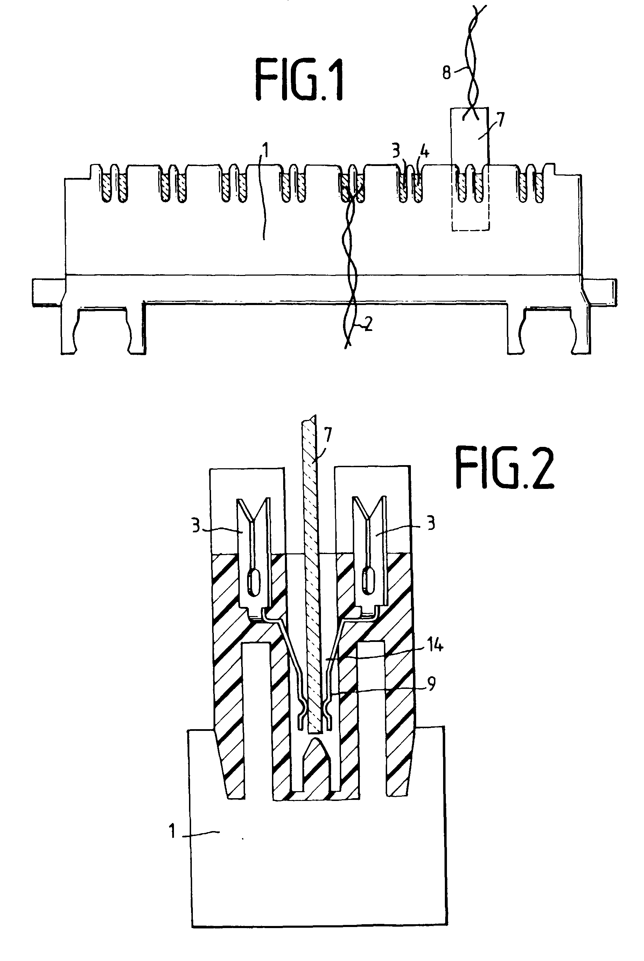

Eine Kontaktleiste 1 für Verteilernetze in der Kommunikations- und Datentechnik besteht üblicherweise aus einem Kunststoff-Gehäuse mit passenden Aufnahmen für die Schneid-Klemm-Kontakte 3, 4 (Fig. 1). Jeweils ein Paar von Schneid-Klemm-Kontakten 3, 4 dient zum Anschließen einer verdrillten Doppelleitung 2. Bei der symmetrisch aufgebauten Kontaktleiste 1 gehört zu jedem Paar von Schneid-Klemm-Kontakten 3, 4 ein zugehöriges Paar auf der gegenüberliegenden Seite der Kontaktleiste 1. Eine Seite der Kontaktleiste 1 bildet die Kabelseite, auf der die vom Amt kommenden Doppelleitungen 2 angeschlossen werden, wohingegen auf der gegenüberliegenden Rangierseite die Doppel leitungen 2 für die Teilnehmer angeschlossen werden. Zum Rangieren von Verbindungen bzw. für Meß- und Prüfzwecke wird in den Mittelabgriff 14 ein Steckverbinder eingeführt. Diese Steckverbinder bestehen im wesentlichen aus einer Leiterplatte 7 und an diese angelöteten verdrillten Doppelleitungen 8 des Patchkabels. Wie in Fig. 2 dargestellt, bilden zwei gegenüberliegende Schneid-Klemm-Kontakte 3 mittels Kontaktfedern 9 den Mittelabgriff 14. In diesem Ausführungsbeispiel bilden die Kontaktfedern 9 einen Trennkontakt, d.h. ohne eingeführten Steckverbinder sind die gegenüberliegenden Schneid-Klemm-Kontakte 3 miteinander elektrisch verbunden. Wird die Leiterplatte 7 des Steckverbinders in den Trennkontakt eingeführt, so wird die Verbindung unterbrochen. Abgegriffen wird dann an den an die Leiterplatte 7 angelöteten verdrillten Doppelleitungen 8 des Patchkabels.

Die Leiterplatte 7 ist im unteren Bereich, der in den Mittelabgriff 14 eingeführt wird, geschlitzt ausgeführt. Auf jeweils einem Steg sind auf der Vorderseite 20 und Rückseite 40 der Leiterplatte 7 Kontaktflächen 21, 22, 23, 24 angeordnet. An diese schließen sich die zugehörigen Leiterbahnen 25, 26, 27, 28 an, die parallel zur Längskante der Leiterplatte 7 verlaufen. Nach ungefähr der Länge von einem Drittel der Leiterplatte 7, knicken die Leiterbahnen 25, 26, 27, 28 zur Außenkante der Leiterplatte 7 hin ab, wobei die Leiterbahnen 25, 26 der Vorderseite 20 nahezu deckungsgleich mit den Leiterbahnen 27, 28 der Rückseite verlaufen. Nach der Abknickung verlaufen die Leiterbahnen 25, 26 der Vorderseite 20 und die Leiterbahnen 27, 28 der Rückseite wieder parallel, aber mit kleinerem Abstand zueinander. Neben der Leiterbahn 26 ist eine kapazitive Fläche 32 angeordnet und an die Leiterbahn 26 angeschlossen. Analog ist auf der Rückseite 40 der Leiterplatte 7 eine kapazitive Fläche 33 neben der Leiterbahn 27 nahezu deckungsgleich mit der kapazitiven Fläche 32 angeordnet. Die Leiterbahn 28 auf der Rückseite 40 der Leiterplatte 7 kreuzt mittels zweier Durchkontaktierungen 29, 30, die auf der Vorderseite 20 mittels einer Leiterbahn 31 miteinander elektrisch verbunden sind, die Leiterbahn 27 und ist mit der kapazitiven Fläche 33 verbunden. Danach verlaufen die Leiterbahnen 27, 28 wieder parallel weiter und werden schließlich an die zugehörigen Lötaugen 37, 39 angeschlossen. Unterhalb des Lötauges 36 ist auf der Rückseite 40 der Leiterplatte 7 eine weitere kapazitive Fläche 35 angeordnet und an die Leiterbahn 27 angeschlossen. Nahezu deckungsgleich zur kapazitiven Fläche 35 auf der Rückseite 40 der Leiterplatte 7 ist eine kapazitive Fläche 34 auf der Vorderseite 20 angeordnet und an die Leiterbahn 25 angeschlossen. Nach ungefähr Zweidrittel der Länge der Leiterplatte 7 winkeln die Leiterbahnen 25, 26 zur gegenüberliegenden Längskante 42 der Leiterplatte 7 hin ab und verlaufen wieder parallel, um dann an die zugehörigen Lötaugen 36, 38 angeschlossen zu werden. An die Lötaugen 36, 38 bzw. 37, 39 werden die zugehörigen verdrillten Doppelleitungen 8 angelötet, an denen das abgegriffene Signal weitergeleitet werden kann. Die Kontaktflächen 21, 22, 23, 24 stellen den elektrischen Kontakt zu den Kontaktfedern 9 der Schneid-Klemm-Kontakte 3, 4 her, die die Mittelabgriffe 14 bilden. Die parallele Leiterbahnführung oberhalb der Kontaktflächen 21, 22, 23, 24 bewirkt einen teilweisen magnetischen Selbstkompensationseffekt mit den Kontaktfedern 9 der Kontaktleiste 1. Die daran anschließende parallele aber enger beianderliegende Leiterbahnführung minimiert das Nebensprechen zu benachbarten Steckverbindern und ermöglicht eine Wellenwiderstandsanpassung zur Vermeidung von Reflexionen. Vorzugsweise wird der Abstand zwischen den Leiterbahnen 25, 26 bzw. 27, 28 im enger beianderliegenden Bereich derart gewählt, daß die so gebildete Doppelleitung einen Wellenwiderstand nahe 100 Ohm aufweist. Durch die nahezu deckungsgleiche Ausführung von Leiterbahnen und kapazitiven Flächen wird eine exakt definierte magnetische und elektrische Kopplung zwischen Vorderseite 20 und Rückseite 40 erzielt. Durch die Kreuzung der Leiterbahn 28 auf der Rückseite 40 der Leiterplatte 7 nach etwa der Hälfte der Länge des Bereiches, in dem die Leiterbahnen eng beianderliegen, der Leiterplatte 7 resultiert eine nahezu vollständige Kompensation des Nebensprechens zwischen Vorderseite 20 und Rückseite 40. Die jeweiligen flächig ausgebildeten Kapazitäten 32, 33 bzw. 34, 35 dienen ebenfalls zur Kompensation des Nebensprechens zwischen der Vorderseite 20 und Rückseite 40 und kompensieren hauptsächlich die Einflüße der Kontaktflächen 21, 22 bzw. 23, 24. Die kapazitiven Flächen 32, 33 und 34, 35 werden vorzugsweise jedoch etwas größer als die Kontaktflächen 21, 22, 23, 24 gewählt, um auch das von der magnetischen Selbstkompensation nicht erfaßte Nebensprechen der Kontaktleiste 1 zu kompensieren.

Die Aufteilung der Kompensation in einen induktiven Anteil (nach der Hälfte der Länge gekreuzte, eng beianderliegende, parallele Leiterbahnen) und einen kapazitiven Anteil (kapazitive Flächen 32, 33 und 34, 35) in dem oben genannten Verhältnis ergibt schließlich eine gute Wellenwiderstandsanpassung und führt somit zu geringen Reflexionen, als wie dies bei einer reinen induktiven oder rein kapazitiven Kompensation der Fall wäre.

## Patentansprüche

1. Leiterplatte für Steckverbinder in symmetrischen Verteilernetzen der Kommunikations- und Datentechnik,
**dadurch gekennzeichnet,**
daß die weitgehend parallelen Leiterbahnen (25, 26) der Vorderseite nahezu deckungsgleich mit den Leiterbahnen (27, 28) der Rückseite der Leiterplatte (7) angeordnet sind, und
daß eine Leiterbahn (28) der Rückseite mittels zweier Durchkontaktierungen (29, 30), die auf der Vorderseite der Leiterplatte (7) durch eine Leiterbahn (31) miteinander elektrisch verbunden sind, eine weitere Leiterbahn (27) der Rückseite kreuzt.

2. Leiterplatte nach Anspruch 1, dadurch gekennzeichnet, daß die Leiterbahnen (25, 26, 27, 28) so dicht wie möglich entlang eines Schlitzes (41) in der leiterplatte verlaufen.

3. Leiterplatte nach Anspruch 1 oder 2, dadurch gekennzeichnet, daß die Leiterbahnen (25, 26 bzw. 27, 28) ausgehend von auf der Leiterplatte angeordneten Kontaktflächen (21, 22 bzw. 23, 24) nach ungefähr einem Drittel der Länge der Leiterplatte (7) abwinkeln, um danach parallel aber enger beianderliegend weiter zu verlaufen.

4. Leiterplatte nach einem der Ansprüche 1 bis 3, dadurch gekennzeichnet, daß an die Leiterbahnen (25, 26, 27, 28) kapazitive Flächen (32, 34, 33, 35) angeschlossen sind.

5. Leiterplatte nach Anspruch 4, dadurch gekennzeichnet, daß die kapazitiven Flächen (32, 33, 34, 35) etwas größer als die zugehörigen Kontaktflächen (22, 24, 21, 23) ausgebildet sind.

6. Leiterplatte nach Anspruch 4 oder 5, dadurch gekennzeichnet, daß die kapazitiven Flächen (32, 33) für ein Teilder Leiterbahnen (26, 28) ungefähr in Höhe der Mitte der Leiterplatte (7) und die kapazitiven Flächen (34, 35) für die weiteren Leiterbahnen (25, 27) unterhalb auf der Leiterplatte angeordneten Lötaugen (36, 37) angeordnet sind.

7. Leiterplatte nach Anspruch 6, dadurch gekennzeichnet, daß ausgehend von den Kontaktflächen (21, 22 bzw. 23, 24) die Leiterbahnen (25, 26 bzw. 27, 28) nach ungefähr einem Drittel der Länge der Leiterplatte (7) zu einer Längskante (42) hin abwinkeln, um danach wieder parallel zur Längskante (42) aber enger beianderliegend weiter zu verlaufen, wobei die Leiterbahnen (25, 26) der Vorderseite nach ungefähr Zweidritteln der Länge der Leiterplatte (7) entgegen der ersten Abwinkelung parallel abwinkeln, dann senkrecht zu den Längskanten (42) verlaufen, erneut senkrecht zu den Lötaugen (36, 37, 38, 39) hin abwinkeln, um danach mit den zugehörigen Lötaugen (36, 38) verbunden zu werden, und die Leiterbahnen (27, 28) der Rückseite nach ungefähr der Hälfte der Länge der Leiterplatte (7) entgegen der ersten Abwinkelung abwinkeln, die eine Leiterbahn (28) im abgewinkelten Verlauf mittels der Durchkontaktierungen (29, 30) die andere Leiterbahn (27) kreuzt, um danach mit dieser wieder parallel zur Längskante (42) zu verlaufen und schließlich mit den zugehörigen Lötaugen (37, 39) verbunden zu werden.

## Claims

1. Printed circuit board for plug connectors in symmetrical distribution networks for communications and data technology,
characterized
in that the largely parallel conductor tracks (25, 26) on the front side are arranged to be virtually superimposed on the conductor tracks (27, 28) on the rear side of the printed circuit board (7), and,
in that one conductor track (28) on the rear side crosses a further conductor track (27) on the rear side by means of two plated-through holes (29, 30) which are electrically connected to one another by means of a conductor track (31) on the front side of the printed circuit board (7).

2. Printed circuit board according to Claim 1, characterized in that the conductor tracks (25, 26, 27, 28) run as densely as possible along a slot (41) in the printed circuit board.

3. Printed circuit board according to Claim 1 or 2, characterized in that the conductor tracks (25, 26 and 27, 28) are angled after about one third of the length of the printed circuit board (7), starting from contact surfaces (21, 22 and 23, 24) which are arranged on the printed circuit board, in order, after this, to run onwards parallel, but closer to one another.

4. Printed circuit board according to one of Claims 1 to 3, characterized in that capacitive areas (32, 34, 33, 35) are connected to the conductor tracks (25, 26, 27, 28).

5. Printed circuit board according to Claim 4, characterized in that the capacitive areas (32, 33, 34, 35) are designed to be somewhat larger than the associated contact areas (22, 24, 21, 23).

6. Printed circuit board according to Claim 4 or 5, characterized in that the capacitive areas (32, 33) for some of the conductor tracks (26, 28) are arranged approximately at the level of the centre of the printed circuit board (7), and the capacitive areas (34, 35) for the further conductor tracks (25, 27) are arranged underneath solder lands (36, 37) which are arranged on the printed circuit board.

7. Printed circuit board according to Claim 6, characterized in that, after about one third of the length of the printed circuit board (7) and starting from the contact areas (21, 22 and 23, 24), the conductor tracks (25, 26 and 27, 28) are angled towards a longitudinal edge (42) in order, after this, to continue to run parallel to the longitudinal edge (42) again, but closer to one another, in which case conductor tracks (25, 26) on the front side are angled parallel in the opposite direction to the first angle, after approximately two thirds of the length of the printed circuit board (7), then run at right angles to the longitudinal edges (42), are once again angled at right angles to the solder lands (36, 37, 38, 39) in order to be connected after this to the associated solder lands (36, 38), and the conductor tracks (27, 28) on the rear side are angled in the opposite direction to the first angle after approximately half the length of the printed circuit board (7), one conductor track (28) crosses the other conductor track (27) in the angled profile by means of the plated-through holes (29, 30) in order, after this, to run, with this conductor track, parallel to the longitudinal edge (42) again and, finally, to be connected to the associated solder lands (37, 39).

## Revendications

1. Carte imprimée pour connecteur à fiches dans des réseaux de distribution symétriques de techniques de communication et d'informatique,
caractérisée en ce que,
les pistes conductrices (25, 26) de la face avant substantiellement parallèles sont agencées de manière à presque coïncider avec les pistes conductrices (27, 28) de la face arrière de la carte imprimée (7) et, en ce qu'une piste conductrice (28) de la face arrière croise une autre piste conductrice (27) de la face arrière, au moyen de deux interconnexions (29, 30), qui sont électriquement reliées entre elles sur la face avant de la carte imprimée (7) par une piste conductrice (31).

2. Carte imprimée suivant la revendication 1, caractérisée en ce que les pistes conductrices (25, 26, 27, 28) passent le plus près possible le long d'une fente (41) dans la carte imprimée.

3. Carte imprimée suivant la revendication 1 ou 2, caractérisée en ce que les pistes conductrices (25, 26 ou selon le cas 27, 28) forment un angle à partir des surfaces de contact (21, 22 ou selon le cas 23, 24) agencées sur la carte imprimée après environ un tiers de la longueur de la carte imprimée (7), pour ensuite continuer parallèlement mais de manière beaucoup plus rapprochée.

4. Carte imprimée suivant l'une quelconque des revendications 1 à 3, caractérisée en ce que des surfaces capacitives (32, 34, 33, 35) sont raccordées aux pistes conductrices (25, 26, 27, 28).

5. Carte imprimée suivant la revendication 4, caractérisée en ce que les surfaces capacitives (32, 33, 34, 35) sont conçues de manière un peu plus grande que les surfaces de contact correspondantes (22, 24, 21, 23).

6. Carte imprimée suivant la revendication 4 ou 5, caractérisée en ce que les surfaces capacitives (32, 33) pour une partie des pistes conductrices (26, 28) sont agencées plus ou moins à hauteur du centre de la carte imprimée (7), et les surfaces capacitives (34, 35) des autres pistes conductrices (25, 27) sont agencées sous les pastilles de brasure (36, 37) agencées sur la carte imprimée.

7. Carte imprimée suivant la revendication 6, caractérisée en ce que, à partir des surfaces de contact (21, 22 ou selon le cas 23, 24), les pistes conductrices (25, 26 ou, selon le cas, 27, 28) forment un angle vers une arête longitudinale (42) après environ un tiers de la longueur de la carte imprimée (7), pour ensuite continuer à nouveau parallèlement par rapport à l'arête longitudinale (42), mais de manière beaucoup plus rapprochée, les pistes conductrices (25, 26) de la face avant formant un angle de manière parallèlement opposée à la première déviation après environ deux tiers de la longueur de la carte imprimée (7), puis continuent verticalement vers les arêtes longitudinales (42), forment à nouveau un angle verticalement vers les pastilles de brasure (36, 37, 38, 39), pour ensuite se connecter aux pastilles de brasure correspondantes (36, 38), et les pistes conductrices (27, 28) de la face arrière forment un angle de manière parallèlement opposée au premier angle après environ la moitié de la longueur de la carte imprimée (7), la une piste conductrice (28) croisant l'autre piste conductrice (27) dans le tracé de l'angle au moyen des interconnexions (29, 30), pour ensuite continuer avec celle-ci à nouveau parallèlement par rapport à l'arête longitudinale (42) et finalement se connecter aux pastilles de brasure correspondantes (37, 39).
